# EUROPEAN PATENT APPLICATION

(11) **EP 4 701 215 A1**
(43) Date of publication of application: **25.02.2026**
(21) Application number: 24811455.5
(22) Date of filing: 14.03.2024
(51) Int. Cl.: H04N 23/68, H04N 23/67, H04N 23/54, H04N 23/55, H04N 25/11, H01L 27/146

(54) **IMAGE PROCESSING DEVICE AND IMAGE PROCESSING METHOD**

(30) Priority: 19.05.2023 KR 20230065044; 24.07.2023 KR 20230096256
(71) Applicant: Samsung Electronics Co., Ltd., Suwon-si, Gyeonggi-do 16677 (KR)
(72) Inventor: JEONG, Sangbum, Suwon-si, Gyeonggi-do 16677 (KR); PARK, Jaehyoung, Suwon-si, Gyeonggi-do 16677 (KR); YOUN, Yeotak, Suwon-si, Gyeonggi-do 16677 (KR); KANG, Kawang, Suwon-si, Gyeonggi-do 16677 (KR); KIM, Yunjeong, Suwon-si, Gyeonggi-do 16677 (KR); MOON, Inah, Suwon-si, Gyeonggi-do 16677 (KR); SONG, Byeongjoo, Suwon-si, Gyeonggi-do 16677 (KR); SHIMOKAWA, Shuichi, Suwon-si, Gyeonggi-do 16677 (KR); WON, Jonghoon, Suwon-si, Gyeonggi-do 16677 (KR); JO, Hyeoncheol, Suwon-si, Gyeonggi-do 16677 (KR)
(74) Representative: Appleyard Lees IP LLP
(86) International application number: PCT/KR2024/095488
(87) International publication number: WO 2024/242518

(57) **Abstract**

An electronic device according to one embodiment may comprise: a camera module including a camera; a memory for storing instruction; and at least one processor operatively connected to the camera module and the memory. The camera module may comprise: a lens unit including at least one lens; an image sensor for converting received light into an electrical signal; and an optical image stabilizer for controlling the position of the lens unit and/or the image sensor on the basis of the movement of the electronic device. The image senor may include a micro lens and a plurality of light-receiving elements disposed at positions corresponding to the micro lens. The instructions, being executed by the at least one processor, may cause the electronic device to acquire a gain calibration value corresponding to image stabilizer operation information about the position of the optical image stabilizer. The instructions, being executed by the at least one processor, may cause the electronic device to, according to the electronic device controlling the operation of the optical image stabilizer on the basis of the image stabilizer operation information, obtain image data from the plurality of light-receiving elements on the basis of the gain calibration value corresponding to the image stabilizer operation information. Various other embodiments are possible.

## Description

### [Technical Field]

The disclosure relates to an image processing device and an image processing method.

### [Background Art]

A camera module capable of capturing and processing images may be applied to an electronic device. For example, a mobile device may include one or more camera modules. The camera module may capture digital images, based on information obtained through an image sensor including a light-receiving element capable of detecting optical signals and outputting them as electrical signals.

The camera module included in the electronic device may include various functions for capturing high-quality digital images. For example, the camera module may include an image stabilizer for preventing image quality degradation caused by shaking of the mobile device caused by a user when the user captures an image while holding the mobile device. For example, the camera module may include an auto-focus adjuster for automatically focusing on a subject.

The above-described information may be provided as related art for the purpose of helping understanding of the disclosure. No claim or determination is made as to whether any of the above-described contents may be applied as prior art related to the disclosure.

### [Disclosure of Invention]

### [Solution to Problem]

An electronic device of an embodiment may include a camera module, a memory for storing instructions, and at least one processor operatively connected to the camera module and the memory. The camera module may include a lens unit including at least one lens, an image sensor for converting received light into an electrical signal, and an optical image stabilizer configured to control the position of at least one of the lens unit or the image sensor, based on the movement of the electronic device. The image senor may include a micro lens, and a plurality of light-receiving elements arranged at positions corresponding to the micro lens. The at least one processor may be configured to, by executing the instructions, acquire a gain calibration value corresponding to image stabilizer operation information about the position of the optical image stabilizer, and according to the controlling of the operation of the optical image stabilizer based on the image stabilizer operation information, obtain image data from the plurality of light-receiving elements, based on the gain calibration value corresponding to the image stabilizer operation information.

A method for acquiring a gain calibration value for calibrating a gain value used to read out a pixel value from an image sensor included in a camera module according to an embodiment may include capturing a first image in a state where an optical image stabilizer included in the camera module is moved to a first position. The method may further include capturing a second image in a state where the optical image stabilizer is moved to a second position different from the first position. The method may further include acquiring gain calibration values for a respective plurality of positions of the optical image stabilizer from at least the first image and the second image. The method may include storing a look-up table including the gain calibration values in the memory.

A computer-readable non-transitory recording medium of an embodiment may store a look-up table including gain calibration values including a first gain calibration value corresponding to a first image captured by an image sensor of a camera module in a state where an optical image stabilizer included in the camera module is moved to a first position, and a second gain calibration value corresponding to a second image captured by the image sensor of the camera module in a state where the optical image stabilizer is moved to a second position different from the first position.

### [Brief Description of Drawings]

FIG. 1 is a block diagram illustrating an electronic device in a network environment according to various embodiments.
FIG. 2 is a block diagram illustrating the camera module according to various embodiments.
FIG. 3 is a diagram illustrating a chief ray incidence angle for an image sensor according to an embodiment.
FIG. 4 is a diagram illustrating the effect of shading on an image sensor according to an embodiment.
FIG. 5 is a diagram conceptually illustrating a construction of an image sensor according to an embodiment.
FIG. 6 is a diagram illustrating examples of patterns of an image sensor according to an embodiment.
FIG. 7 is a diagram illustrating a construction of an electronic device according to an embodiment.
FIG. 8 is a flowchart illustrating a process for processing an image in an electronic device according to an embodiment.
FIG. 9 is a flowchart illustrating a process for obtaining an image in an electronic device according to an embodiment.
FIG. 10 is a flowchart illustrating a process for acquiring a gain calibration value for a camera of an electronic device according to an embodiment.
FIG. 11 is a diagram conceptually illustrating the position of a lens or image sensor related to the operation of an optical image stabilizer for acquiring a gain calibration value according to an embodiment.
FIG. 12 is a diagram conceptually illustrating a gain calibration value acquired according to an embodiment.
FIG. 13 is a diagram schematically illustrating the output values of pixels output from an image sensor according to an embodiment.

### [Mode for the Invention]

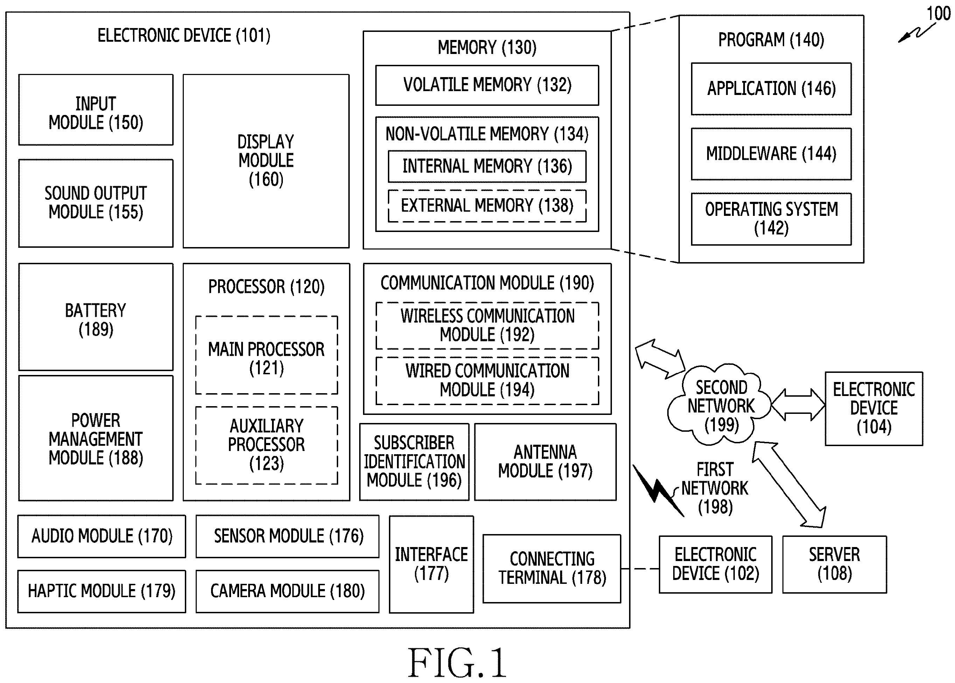

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

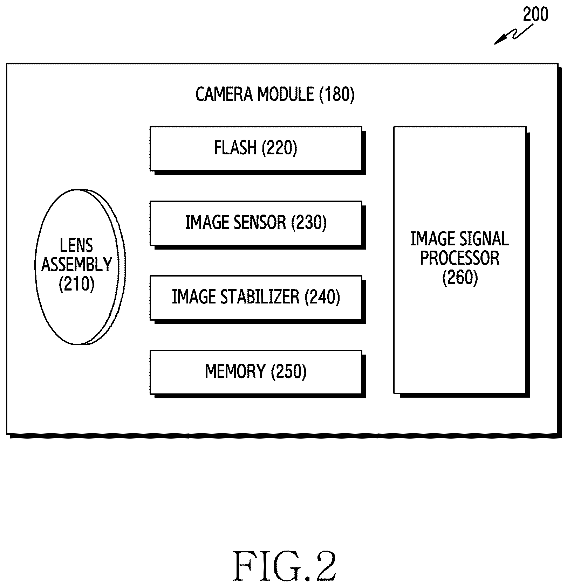

FIG. 2 is a block diagram 200 illustrating the camera module 180 according to various embodiments. Referring to FIG. 2, the camera module 180 may include a lens assembly 210, a flash 220, an image sensor 230, an image stabilizer 240, memory 250 (e.g., buffer memory), or an image signal processor 260. The lens assembly 210 may collect light emitted or reflected from an object whose image is to be taken. The lens assembly 210 may include one or more lenses. According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light reflected from an object. According to an embodiment, the flash 220 may include one or more light emitting diodes (LEDs) (e.g., a red-green-blue (RGB) LED, a white LED, an infrared (IR) LED, or an ultraviolet (UV) LED) or a xenon lamp. The image sensor 230 may obtain an image corresponding to an object by converting light emitted or reflected from the object and transmitted via the lens assembly 210 into an electrical signal. According to an embodiment, the image sensor 230 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect (e.g., image blurring) by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer. The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display device 160. Thereafter, if a specified condition is met (e.g., by a user's input or system command), at least part of the raw image stored in the memory 250 may be obtained and processed, for example, by the image signal processor 260. According to an embodiment, the memory 250 may be configured as at least part of the memory 130 or as a separate memory that is operated independently from the memory 130.

The image signal processor 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 260 may perform control (e.g., exposure time control or read-out timing control) with respect to at least one (e.g., the image sensor 230) of the components included in the camera module 180. An image processed by the image signal processor 260 may be stored back in the memory 250 for further processing, or may be provided to an external component (e.g., the memory 130, the display device 160, the electronic device 102, the electronic device 104, or the server 108) outside the camera module 180. According to an embodiment, the image signal processor 260 may be configured as at least part of the processor 120, or as a separate processor that is operated independently from the processor 120. If the image signal processor 260 is configured as a separate processor from the processor 120, at least one image processed by the image signal processor 260 may be displayed, by the processor 120, via the display device 160 as it is or after being further processed.

According to an embodiment, the electronic device 101 may include a plurality of camera modules 180 having different attributes or functions. In such a case, at least one of the plurality of camera modules 180 may form, for example, a wide-angle camera and at least another of the plurality of camera modules 180 may form a telephoto camera. Similarly, at least one of the plurality of camera modules 180 may form, for example, a front camera and at least another of the plurality of camera modules 180 may form a rear camera.

An electronic device and an image processing method of various embodiments may improve the image quality of a captured image by using an optical image stabilizer.

An electronic device and an image processing method of various embodiments may calibrate shading artifacts occurring in an image obtained through an image sensor having symmetrical phase detection pixels.

The technical task to be achieved in this document is not limited to the technical tasks mentioned above, and other technical tasks not mentioned will be clearly understood by those skilled in the art to which the present invention pertains from the description of the disclosure.

An electronic device of various embodiments disclosed in this document may take various forms. The electronic device may include, for example, a portable communication device (e.g., smartphone), a computer device, a portable multimedia device, a portable medical device, a camera, a wearable device, or a home appliance. The electronic device of embodiments of this document is not limited to the aforementioned devices.

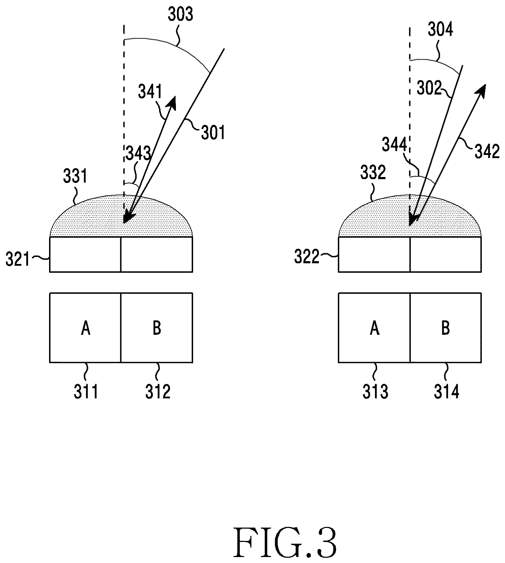

FIG. 3 is a diagram illustrating a chief ray incident angle for an image sensor (e.g., image sensor 230 of FIG. 2) according to an embodiment.

In an embodiment, an image sensor (e.g., image sensor 230 of FIG. 2) may include a plurality of micro lenses (331 and 332) and a plurality of light-receiving elements (311, 312, 313, and 314). The plurality of micro lenses (331 and 332) may include an imaging means for channeling a light path and forming an image. For example, the plurality of micro lenses (331 and 332) may form a micro lens array. Light passing through each of the micro lenses (331 and 332) may pass through a color filter (321 or 322) arranged at a position corresponding to each of the micro lenses (331 and 332), and be incident on at least one of the light-receiving elements (311, 312, 313, and 314). The color filter (321 or 322) may include a color filtering means for filtering a wavelength of light passing through. The light-receiving elements (311, 312, 313, and 314) may include a light detection means for converting received light into an electrical signal. For example, the light-receiving elements (311, 312, 313, and 314) may include photo diodes (PD). A plurality of the light-receiving elements (311, 312, 313, and 314) may be disposed over one micro lens (331 or 332) in order to detect a phase difference for controlling an auto-focus function. For example, the light-receiving elements (311, 312, 313, and 314) may be arranged in a symmetrical array with respect to one micro lens (331 or 332). For example, the light-receiving elements (or photodiodes) may be arranged in a 2 x 2 array with respect to one micro lens (331 or 332). However, the 2 x 2 array is only an example, and an M x N (M, N are natural numbers) array of light-receiving elements (or photodiodes) arranged with respect to one micro lens (331 or 332) may be constructed in various ways. In the disclosure, the embodiment is described based on an example in which pixels including light-receiving elements are arranged in a square shape, but is not limited thereto. An image sensor (e.g., image sensor (230) of FIG. 2) of an embodiment may be arranged in various ways within a range in which values detected from pixels have symmetry (or linearity). For example, the image sensor (e.g., image sensor (230) of FIG. 2) of an embodiment may also include pixels arranged in a diamond shape in which a square is rotated 45 degrees.

In an embodiment, the output of each light-receiving element may have a sensitivity deviation depending on a chief ray angle (CRA) at which a chief ray of light incident on the image sensor (e.g., image sensor (230) of FIG. 2) forms with respect to an optical axis. Referring to FIG. 3, a chief ray angle (303 or 304) for a lens chief ray (301 or 302) of the micro lens may vary depending on an optical position of micro lens, and a sensor chief ray angle (343 and 344) for a sensor chief ray (341 and 342) of the light-receiving element may be designed differently for each field. When the output of each light-receiving element is used as a pixel and generates image data, a deviation of an output pixel value may occur depending on the physical positions of the micro lenses (331 and 332) and the light-receiving elements (311, 312, 313, and 314). The deviation of the pixel value caused by the physical positions of the micro lenses (331 and 332) and the light-receiving elements (311, 312, 313, and 314) rather than light received from a subject may be referred to as a shading effect. For example, among the light-receiving element (311) and the light-receiving element (312), the light-receiving element (312) may receive light according to the lens chief ray (301). Among the light-receiving element (313) and the light-receiving element (314), the light-receiving element (313) may receive light according to the lens chief ray (302). This may cause the deviation of the pixel value.

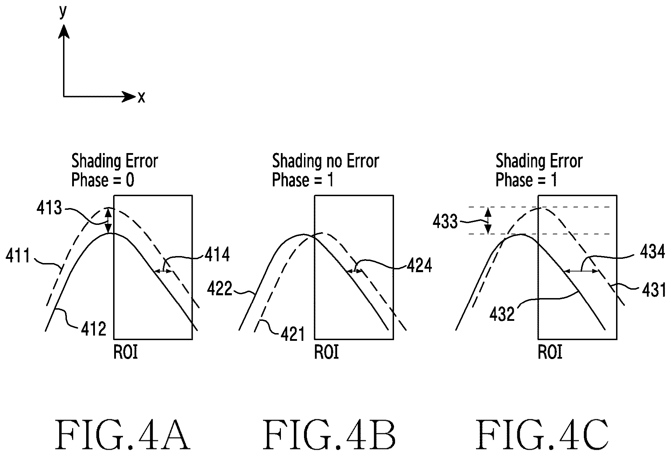

FIG. 4 is a diagram illustrating the effect of shade on an image sensor (e.g., image sensor (230) of FIG. 2) according to an embodiment.

The x-axis of FIG. 4 may represent the position of a pixel within a field of an image when the field of the image obtained through the image sensor (e.g., image sensor (230) of FIG. 2) is represented one-dimensionally. The y-axis of FIG. 4 may represent an output value (or pixel gain value) of a light-receiving element at a corresponding pixel position.

FIG. 4 (a) illustrates a case where there is no phase difference between output values (411) of first light-receiving elements (e.g., light-receiving elements (311) of FIG. 3) arranged at a first position within each pixel and output values (412) of second light-receiving elements (e.g., light-receiving elements (312) of FIG. 3) arranged at a second position within each pixel, and an error (413) due to the shading effect occurs. FIG. 4 (b) illustrates a case where there is a phase difference (424), without an error due to the shading effect, between output values (421) of the first light-receiving elements (e.g., light-receiving elements (311) of FIG. 3) arranged at the first position within each pixel and output values (422) of the second light-receiving elements (e.g., light-receiving elements (312) of FIG. 3) arranged at the second position within each pixel. Referring to FIG. 4 (a) and (b), in the case shown in FIG. 4 (a), there is no phase difference originally, but when comparing the output values (411 and 412) within a region of interest (ROI), it may be determined that there is a phase difference (414). When comparing graphs within the region of interest (ROI) shown in FIG. 4 (a) and (b), it may not be possible to distinguish between the case where the error (413) due to the shading effect occurs and the case where there is the phase difference (424).

In addition, FIG. 4 (c) illustrates a case where there is a phase difference between output values (431) of the first light-receiving elements (e.g., light-receiving element (311) of FIG. 3) each arranged within a pixel and output values (432) of the second light-receiving elements (e.g., light-receiving element (312) of FIG. 3) each arranged within the pixel, and an error (433) due to the shading effect also occurs. Referring to FIG. 4 (c), an inaccurate phase difference (434) may be detected within a region of interest (ROI) because of the error (433) due to the shading effect.

An electronic device (e.g., electronic device (101) of FIG. 1) of an embodiment may convert a color pattern of image data obtained from the image sensor (230) into a pattern (e.g., Bayer pattern) capable of performing color image conversion processing. The operation of converting the image data into a color image in order to perform the color image conversion processing may be referred to as a demosaic operation. The operation of converting the color pattern of the image data may be referred to as a remosaic operation. When the remosaic operation is performed without correcting the shading effect reflected in the image data, a resolution of an image may be reduced.

An electronic device (e.g., electronic device (101) of FIG. 1) of an embodiment may perform an auto-focus function for adjusting the focus of a camera included in a camera module (e.g., camera module (180) of FIGS. 1 and 2), based on a phase difference of values detected through light-receiving elements (e.g., light-receiving elements (311 and 312) of FIG. 1). To perform the auto-focus function, the electronic device (e.g., electronic device (101) of FIG. 1) of an embodiment may utilize a bundled image for first light-receiving elements (e.g., light-receiving elements (311 and 313) of FIG. 3) and a bundled image for second light-receiving elements (e.g., light-receiving elements (312 and 324) of FIG. 3). When a focused calculation is performed without correcting the shading effect reflected in the detected values, the accuracy of the auto-focus function may be reduced due to low-frequency noise not related to a subject.

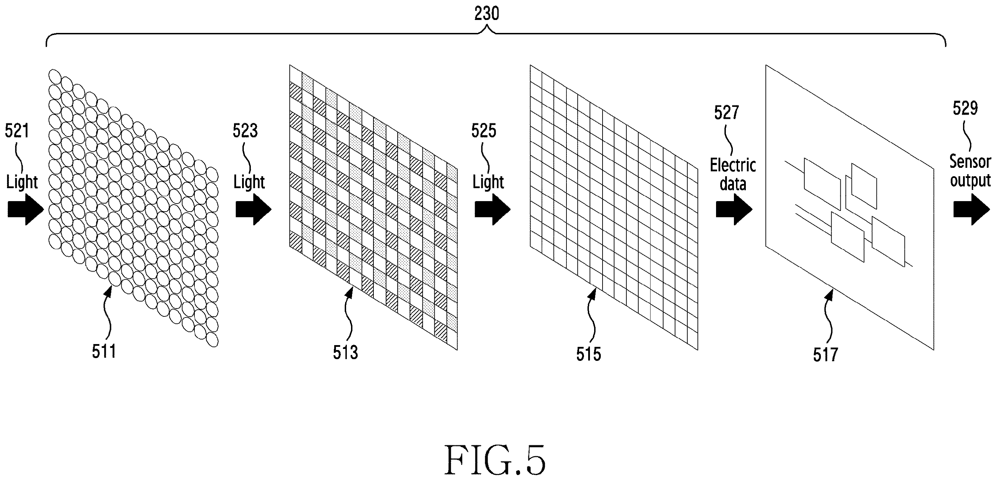

FIG. 5 is a diagram conceptually illustrating the construction of an image sensor (e.g., image sensor (230) of FIG. 2) according to an embodiment.

In an embodiment, the image sensor (230) may include a micro lens array (MLA) (511), a color filter (513), a light-receiving unit (515), and a calculation unit (517).

In an embodiment, the micro lens array (511) may be configured such that a light bundle (521) that passes through a lens unit (e.g., lens assembly (210) of FIG. 2) and forms an image on the image sensor (230) is focused on a light-receiving element of the light-receiving unit (515). A light bundle (523) that passes through the micro lens array (511) may be blocked at at least a portion of wavelengths other than a band corresponding to a specific color, as the light bundle (523) passes through the color filter (513). A light bundle (525) that passes through the color filter (513) may be detected by the light-receiving element (e.g., photodiode) of the light-receiving unit (515). The light-receiving unit (515) may include a light-receiving element for, when receiving light, generating a charge and converting it into an electrical signal, and a circuit for selectively reading out the charge of the light-receiving element. A circuit for digitizing a signal read out from the light receiving unit (515) or reducing noise may be arranged between the light receiving unit (515) and the calculation unit (517).

In an embodiment, the calculation unit (517) may perform an operation of processing electric data (527) that is output from the light receiving unit (515). The calculation unit (517) may output data that is obtained based on a calculation result. The output of the calculation unit (517) may be the output of the image sensor (230). In an embodiment, the calculation unit (517) may perform an operation of calibrating the read data, as the operation of processing the electric data (527). For example, the operation performed by the calculation unit (517) may include at least one of a calculation for reducing a deviation between pixels due to optical characteristics or relative positions of sensors, a calculation for reducing noise generated in an analog signal, a calculation for removing defects, a calculation for performing remosaic, or a calculation according to a specific application (e.g., proximity sensor function, timing adjustment function, and HDR tone mapping function). In an embodiment, the electronic device (e.g., electronic device (101) of FIG. 1) may be also configured such that another processor (e.g., application processor) performs the calculation performed by the calculation unit (517). A sensor output (529) that is output from the calculation unit (517) may be input to at least one processor (e.g., application processor) through an interface.

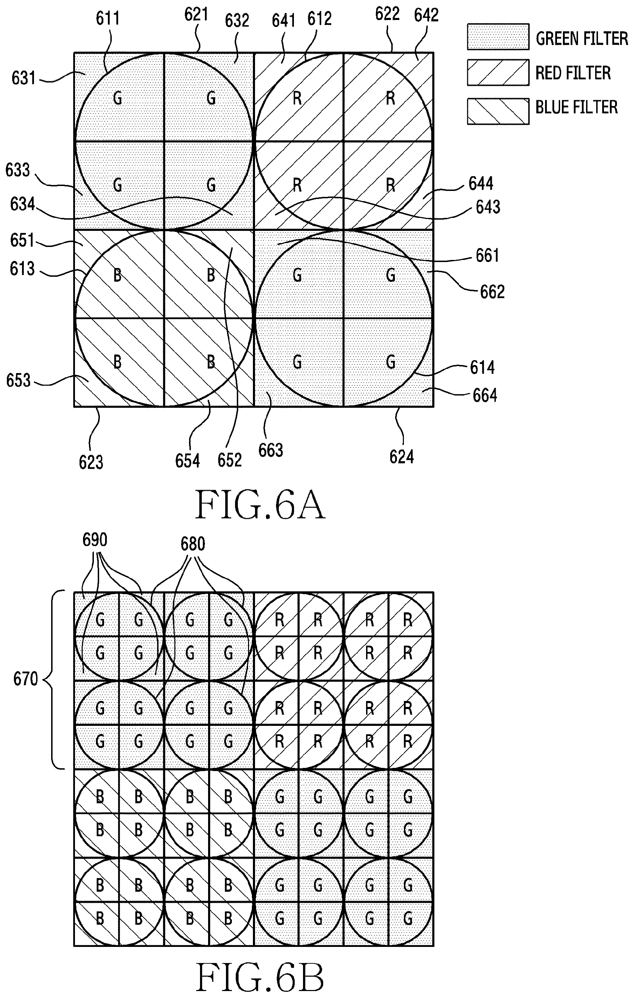

FIG. 6 is a diagram illustrating examples of patterns of an image sensor (e.g., image sensor (230) of FIG. 2) according to an embodiment.

In an embodiment, an image sensor (e.g., image sensor (230) of FIG. 2) may include a plurality of micro lenses (e.g., micro lens (511) of FIG. 5), a color filter (e.g., color filter (513) of FIG. 5), and light-receiving elements (e.g., light-receiving unit (515) of FIG. 5). A plurality of light-receiving elements included in the light-receiving elements (e.g., light-receiving unit (515) of FIG. 5) may be arranged at positions corresponding to one micro lens. Referring to FIG. 6 (a), a first light-receiving element (631), a second light-receiving element (632), a third light-receiving element (633), and a fourth light-receiving element (634) arranged in a 2 x 2 array may be arranged at positions corresponding to a first micro lens (611). The color filter (e.g., color filter (513) of FIG. 5) may be configured such that a green channel (621) is formed at a position corresponding to the first micro lens (611). A fifth light-receiving element (641), a sixth light-receiving element (642), a seventh light-receiving element (643), and an eighth light-receiving element (644) may be arranged at positions corresponding to a second micro lens (612). The color filter (e.g., color filter (513) of FIG. 5) may be configured such that a red channel (622) is formed at a position corresponding to the second micro lens (612). A ninth light-receiving element (651), a tenth light-receiving element (652), an eleventh light-receiving element (653), and a twelfth light-receiving element (654) may be arranged at positions corresponding to a third micro lens (613). The color filter (e.g., color filter (513) of FIG. 5) may be configured such that a blue channel (623) is formed at a position corresponding to the third micro lens (613). A thirteenth light-receiving element (661), a fourteenth light-receiving element (662), a fifteenth light-receiving element (663), and a sixteenth light-receiving element (664) may be arranged at positions corresponding to a fourth micro lens (614). The color filter (e.g., color filter (513) of FIG. 5) may be configured such that a green channel (624) is formed at a position corresponding to the fourth micro lens (614).

The image sensor (e.g., image sensor (230) of FIG. 2) of an embodiment may be configured such that a pattern illustrated in FIG. 6 (a) is repeated. However, in an embodiment, the pattern configured by the image sensor (e.g., image sensor (230) of FIG. 2) is not limited to the pattern illustrated in FIG. 6 (a). In an embodiment, a plurality of micro lenses may be arranged at positions corresponding to the same color channel. Referring to FIG. 6 (b), four micro lenses (680) may be arranged at positions corresponding to an area where a green filter (670) is arranged. Four light-receiving elements (690) may be arranged for each of the micro lenses (680).

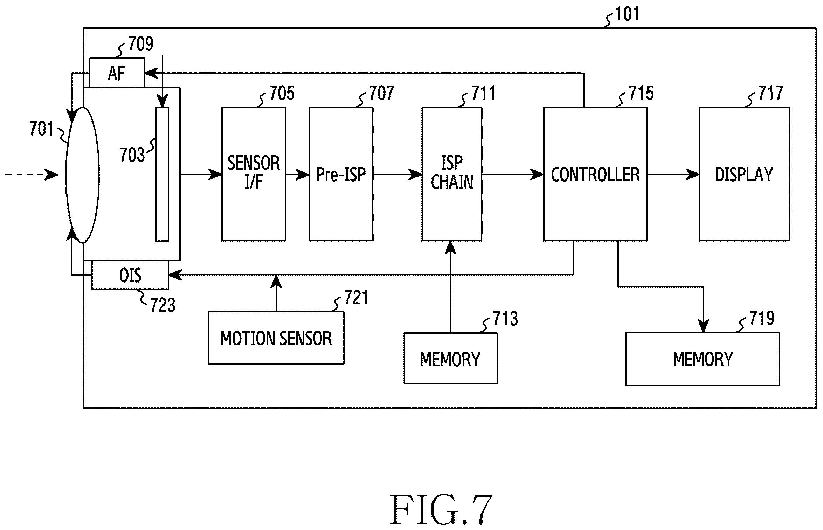

FIG. 7 is a diagram illustrating a construction of an electronic device (101) (e.g., electronic device (101) of FIG. 1) according to an embodiment.

In an embodiment, an electronic device (101) may include a lens unit (701) (e.g., lens assembly (210) of FIG. 2), an image sensor (703) (e.g., image sensor (230) of FIG. 2), a sensor interface (I/F) (705), a Pre-ISP (707), an ISP chain (711), a controller (715) (e.g., processor (120) of FIG. 1), a display (717) (e.g., display module (160) of FIG. 1), memories (713 and 719) (e.g., memory (130) of FIG. 1), a motion sensor (721) (e.g., sensor module (176) of FIG. 1), an optical image stabilizer (OIS) (723) (e.g., image stabilizer (240) of FIG. 2), and an auto-focus (AF) adjuster (709).

In an embodiment, light information from a subject incident through the lens unit (701) may be converted into an electrical signal by the image sensor (703) and be input to an image signal processor (e.g., image signal processor (260) of FIG. 2) including the Pre-ISP (707) and the ISP chain (711) via the sensor interface (705). An infrared (IR) cut filter may be disposed on an upper surface of the image sensor (703). Light from the subject passing through the lens unit (701) may be partially filtered by the IR cut filter and then be detected by the image sensor (703).

In an embodiment, the Pre-ISP (707) block may perform an operation related to an image signal before the ISP chain (711) performs image signal processing. For example, the Pre-ISP (707) block may perform auto white balance (AWB), auto exposure (AE), and auto focusing (AF) operations.

In an embodiment, the ISP chain (711) may process an image signal obtained through the image sensor (703). For example, the ISP chain (711) may perform at least one of lens shading correction, dead pixel correction, noise adjustment, tone curve adjustment, edge enhancement, demosaic, or remosaic. In FIG. 7, the Pre-ISP (707) block and the ISP chain (711) block are illustrated separately from the image sensor (703) and the controller (715). However, at least a portion of the Pre-ISP (707) and the ISP chain (711) may be also implemented through a calculation unit (e.g., calculation unit (517) of FIG. 5) included in the image sensor (703) or through the controller (715).

In an embodiment, the Pre-ISP (707) and the ISP chain (711) may be implemented through at least one of a processor (or integrated circuit) included in the image sensor (703), a processor (or integrated circuit) included in the controller (715), or a separate processor (or integrated circuit).

In an embodiment, the controller (715) may control the display (717) to display an execution screen of an application executed by the controller (715) or an image stored in the memory (719). The memory (719) may include, for example, a non-volatile memory such as a flash memory. The controller (715) may display a preview screen, which displays image data obtained through the image sensor (703) in real time, through the display (717).

In an embodiment, the motion sensor (721) may detect the movement of the electronic device (101). For example, the motion sensor (721) may include a gyro sensor. To eliminate or reduce shaking of a captured image, the optical image stabilizer (723) may cancel out the movement of the electronic device (101) by moving the lens (701) or the image sensor (703) in response to the movement of the electronic device (101). For example, the electronic device (101) may analyze the motion sensor (721) or the captured image and determine the movement of the electronic device (101), and control the optical image stabilizer (723), based on the determined movement.

In an embodiment, the ISP chain (711) may perform shading correction, based on image stabilizer operation information related to the operation of the optical image stabilizer (723). The image stabilizer operation information may include information related to the operation of the optical image stabilizer (723). For example, the image stabilizer operation information may include a value related to a position of the optical image stabilizer (723) dependent on the operation of the optical image stabilizer (723). For example, the value related to the position of the optical image stabilizer (723) may include position information measuring the position of the optical image stabilizer (723). The position of the optical image stabilizer (723) may be detected through a position sensor (e.g., Hall sensor, tunnel magneto resistance (TMR) sensor, giant magneto resistance (GMR) sensor, or anisotropic magneto resistance (AMR) sensor), but it may also be configured to detect the position information without the position sensor. For example, the value related to the position of the optical image stabilizer (723) may also include a control value for controlling a current value flowing in a coil included in the optical image stabilizer (723).

In an embodiment, the ISP chain (711) may acquire a gain calibration value for performing shading correction, based on the image stabilizer operation information related to the operation of the optical image stabilizer (723). For example, the memory (713) may store a look-up table configured to determine a gain calibration value, based on the image stabilizer operation information. For example, the memory (713) may also store an algorithm for calculating to determine a gain calibration value according to a defined formula, based on the image stabilizer operation information. For example, the gain calibration value may be also acquired based on the look-up table stored in the memory (713) and a calculation performed according to a specified formula. In an embodiment, the image sensor (709) may also bin the output of two or more light-receiving elements and output. In an embodiment, for example, the memory (713) may further store a gain calibration value for output values that are output by binning the two or more light-receiving elements. In an embodiment, for example, the electronic device (101) may also calibrate the output value, based on the gain calibration value for the two light-receiving elements that are merged when the image sensor (709) bins the two or more light-receiving elements and outputs. By applying the gain calibration value to raw image data obtained from the image sensor (703), the ISP chain (711) may obtain calibrated image data. For example, the calibrated image data may be obtained by calibrating a gain value of a signal output from each pixel (or each light-receiving element), based on the gain calibration value. For example, the ISP chain (711) may be configured to determine the gain calibration value through a calculation performed based on the image stabilizer operation information.

In an embodiment, the electronic device (101) may obtain image data, based on the determined gain calibration value. The electronic device (101) (e.g., ISP chain (711)) may determine a phase difference between pixels, based on the image data calibrated based on the gain calibration value. The electronic device (101) may control the auto-focus adjuster (709) to adjust a focus, based on the determined phase difference. By detecting the phase difference based on the image data calibrated for the shading effect caused by the operation of the optical image stabilizer (723), the auto-focus function performed in conjunction with the operation of the optical image stabilizer (723) may be improved.

In an embodiment, the electronic device (101) may perform a remosaic operation of converting color patterns of included pixels, based on the image data calibrated based on the determined gain calibration value. By performing the remosaic operation based on the image data calibrated for the shading effect caused by the operation of the optical image stabilizer (723), remosaic performance may be improved.

In an embodiment, the image sensor (703) may include a plurality of sensing lines constituting a unit that reads out arrayed light-receiving elements. Each of the plurality of sensing lines may be configured to read out pixel values of two or more pixels. The image sensor (703) may be configured to read out the pixel values, based on gain calibration values for light-receiving elements included in the sensing line that reads out the pixel values.

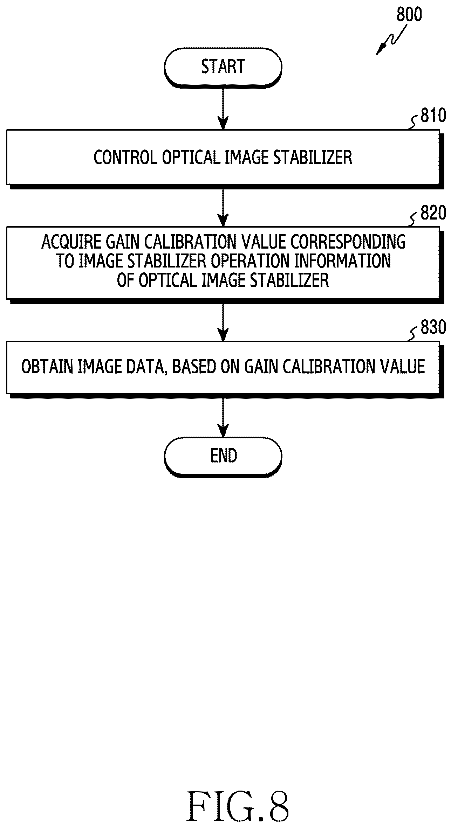

FIG. 8 is a flowchart (800) illustrating a process of processing an image in an electronic device (e.g., electronic device (101) of FIG. 1 or electronic device (101) of FIG. 7) according to an embodiment.

In operation 810, an electronic device (e.g., electronic device (101) of FIG. 1 or electronic device (101) of FIG. 7) of an embodiment may control an optical image stabilizer (OIS) (e.g., image stabilizer (240) of FIG. 2 or optical image stabilizer (723) of FIG. 7), based on physical movement of the electronic device (e.g., electronic device (101) of FIG. 1 or electronic device (101) of FIG. 7). For example, the electronic device (e.g., electronic device (101) of FIG. 1 or electronic device (101) of FIG. 7) may move an OIS carrier included in the optical image stabilizer (e.g., image stabilizer (240) of FIG. 2 or optical image stabilizer (723) of FIG. 7), based on a result of detecting the physical movement of the electronic device (e.g., electronic device (101) of FIG. 1 or electronic device (101) of FIG. 7).

In operation 820, the electronic device (e.g., electronic device (101) of FIG. 1 or electronic device (101) of FIG. 7) of an embodiment may obtain image stabilizer operation information related to the control of the optical image stabilizer (e.g., image stabilizer (240) of FIG. 2 or image stabilizer (723) of FIG. 7). For example, the electronic device (e.g., electronic device (101) of FIG. 1 or electronic device (101) of FIG. 7) may obtain position information about the optical image stabilizer (e.g., image stabilizer (240) of FIG. 2 or image stabilizer (723) of FIG. 7). For example, the electronic device (e.g., electronic device (101) of FIG. 1 or electronic device (101) of FIG. 7) may also be configured to obtain information for controlling the optical image stabilizer (e.g., image stabilizer (240) of FIG. 2 or image stabilizer (723) of FIG. 7).

In an embodiment, the electronic device (e.g., electronic device (101) of FIG. 1 or electronic device (101) of FIG. 7) may acquire a gain calibration value for correcting a shading effect, based on the image stabilizer operation information related to the operation of the optical image stabilizer (e.g., image stabilizer (240) of FIG. 2 or image stabilizer (723) of FIG. 7). For example, the electronic device (e.g., electronic device (101) of FIG. 1 or electronic device (101) of FIG. 7) may acquire a gain calibration value, based on the image stabilizer operation information from a look-up table stored in a memory (e.g., memory (130) of FIG. 1 or memory (713) of FIG. 7). For example, the electronic device (e.g., electronic device (101) of FIG. 1 or electronic device (101) of FIG. 7) may also acquire a gain calibration value by performing a predefined operation for the image stabilizer operation information.

In operation 830, the electronic device (e.g., electronic device (101) of FIG. 1 or electronic device (101) of FIG. 7) may obtain image data, based on the gain calibration value. The electronic device (e.g., electronic device (101) of FIG. 1 or electronic device (101) of FIG. 7) may apply the gain calibration value to raw image data obtained through an image sensor (e.g., image sensor (230) of FIG. 2 or image sensor (703) of FIG. 7). As a gain value for canceling out the shading effect is applied to pixel values included in the raw image data, calibrated image data calibrated for the shading effect may be obtained.

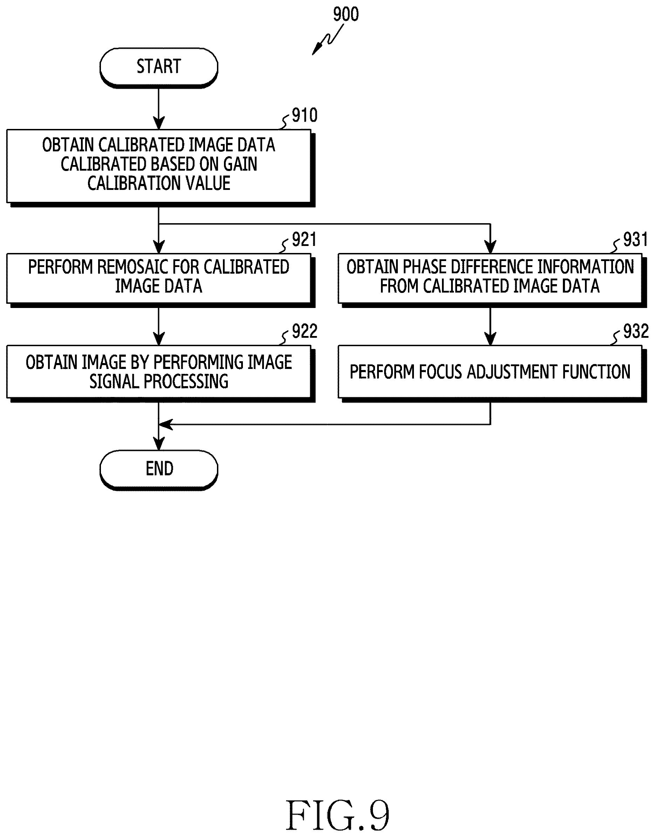

FIG. 9 is a flowchart (900) illustrating a process of obtaining an image in an electronic device (e.g., electronic device (101) of FIG. 1 or electronic device (101) of FIG. 7) according to an embodiment.

In operation 910, an electronic device (e.g., electronic device (101) of FIG. 1 or electronic device (101) of FIG. 7) of an embodiment may obtain calibrated image data that is calibrated based on a gain calibration value (e.g., gain calibration value acquired in operation 820 of FIG. 8). The gain calibration value may include gain values to be applied to respective pixels of an image. The calibrated image data may be obtained by applying a gain corresponding to the gain calibration value to each of at least some of pixel values included in raw image data. The gains applied to the respective pixels may be different from each other.

In operation 921, the electronic device (e.g., electronic device (101) of FIG. 1 or electronic device (101) of FIG. 7) of an embodiment may perform a remosaic operation for the calibrated image data. The remosaic operation may include an operation of converting color patterns of pixels included in image data into different patterns. For example, a Bayer image having a Bayer pattern may be obtained by performing the remosaic operation for image data having the pattern illustrated in FIG. 6 (a) or the pattern illustrated in FIG. 6 (b). In an embodiment, since a shading effect is removed or reduced in the calibrated image data, the electronic device (e.g., electronic device (101) of FIG. 1 or electronic device (101) of FIG. 7) may obtain image data of a higher resolution through the remosaic operation.

In operation 922, the electronic device (e.g., electronic device (101) of FIG. 1 or electronic device (101) of FIG. 7) of an embodiment may obtain an image by performing image signal processing for the image data to which the remosaic has been applied in operation 921. For example, the image signal processing may include at least one of demosaic, dead pixel correction, noise adjustment, tone curve adjustment, or edge enhancement. The demosaic may refer to an operation of converting image data into a color image. For example, the electronic device (e.g., electronic device (101) of FIG. 1 or electronic device (101) of FIG. 7) may obtain an RGB color image whose each pixel has an RGB value from image data having a Bayer pattern, through the demosaic operation. The dead pixel correction may refer to correcting dead pixel values included in the image data. The noise adjustment may refer to detecting and reducing noise within an image. The tone curve adjustment may refer to an operation of mapping a tone of the image data. The edge enhancement may refer to an operation of detecting edges included in the image and calibrating the image to make clearer.

In operation 931, the electronic device (e.g., electronic device (101) of FIG. 1 or electronic device (101) of FIG. 7) of an embodiment may obtain phase difference information from the calibrated image data. For example, the electronic device (e.g., electronic device (101) of FIG. 1 or electronic device (101) of FIG. 7) may obtain phase difference information between images from two or more images included in the calibrated image data.

In operation 932, the electronic device (e.g., electronic device (101) of FIG. 1 or electronic device (101) of FIG. 7) of an embodiment may perform a focus adjustment function, based on the phase difference information. The electronic device (e.g., electronic device (101) of FIG. 1 or electronic device (101) of FIG. 7) may estimate a distance to a subject based on the phase difference information, move a lens included in a camera module (e.g., camera module (180) of FIGS. 1 and 2) included in the electronic device (e.g., electronic device (101) of FIG. 1 or electronic device (101) of FIG. 7), and adjust a focus. By removing the shading effect from the output of the image sensor, the accuracy of the focus adjustment function may be improved.

In an embodiment, the calibrated image data obtained in operation 910 may be used for operations other than the operations described above. For example, the calibrated image data may be used for operations such as vertical phase difference calculation, horizontal phase difference calculation, or flare detection.

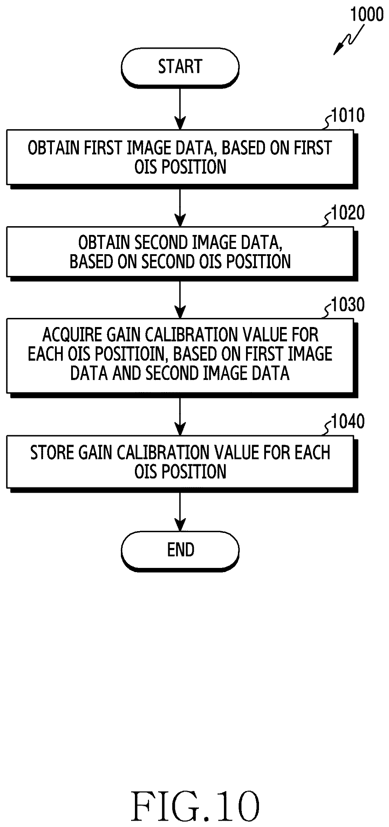

FIG. 10 is a flowchart (1000) illustrating a process of acquiring a gain calibration value for a camera (e.g., camera module (180) of FIGS. 1 and 2) of an electronic device (e.g., electronic device (101) of FIG. 1 or electronic device (101) of FIG. 7) according to an embodiment. Operations included in the flowchart (1000) may be performed during a manufacturing process or development process of manufacturing the electronic device (e.g., electronic device (101) of FIG. 1 or electronic device (101) of FIG. 7). However, the disclosure is not limited thereto. The operations included in the flowchart (1000) may also be performed by the completed electronic device (e.g., electronic device (101) of FIG. 1 or electronic device (101) of FIG. 7).

In an embodiment, a gain calibration value may be acquired based on the results of capturing images at two or more positions where at least one of the position of an optical image stabilizer (e.g., image stabilizer (240) of FIG. 2 or optical image stabilizer (723) of FIG. 7) or the position of an auto-focus adjuster (e.g., auto-focus adjuster (709) of FIG. 7) is different from each other.

According to an embodiment, in operation 1010, first image data may be obtained through a camera (e.g., camera module (180) of FIGS. 1 and 2) of the electronic device (e.g., electronic device (101) of FIG. 1 or electronic device (101) of FIG. 7) in a state where an optical image stabilizer (e.g., image stabilizer (240) of FIG. 2 or optical image stabilizer (723) of FIG. 7) is positioned at a first OIS position. The first image data may be an image obtained by photographing a surface light source having a constant gain over the entire area, based on the first OIS position.

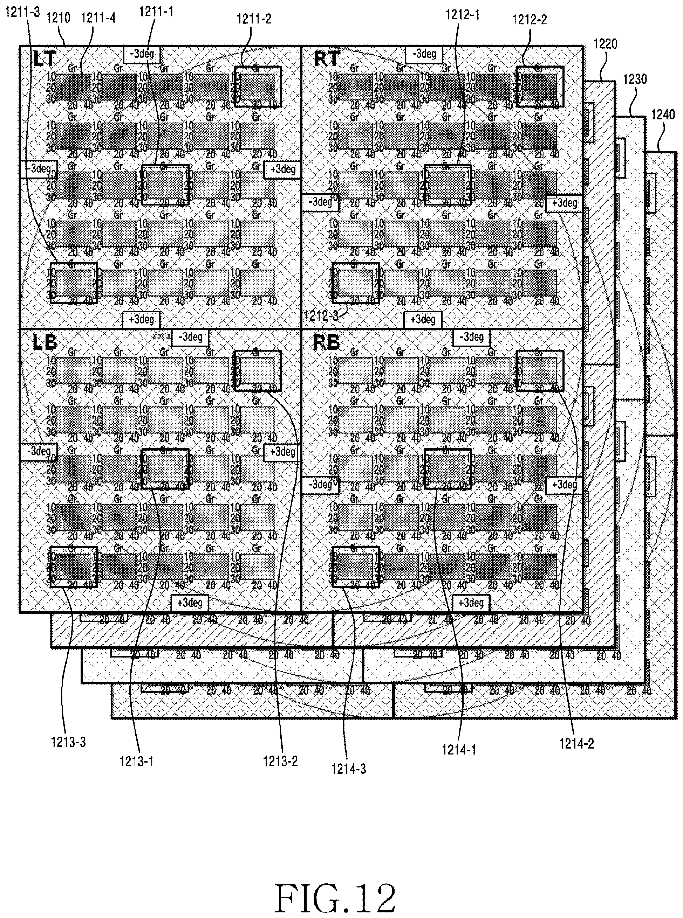

According to an embodiment, in operation 1020, second image data may be obtained through the camera (e.g., camera module (180) of FIGS. 1 and 2) in a state where the optical image stabilizer (e.g., image stabilizer (240) of FIG. 2 or optical image stabilizer (723) of FIG. 7) is positioned at a second OIS position different from the first OIS position. For example, the second OIS position may include a center point of an area in which the optical image stabilizer may move or a position symmetrical with the first OIS position with respect to the center point. In the disclosure, the center point may mean the center of a movement range of an image sensor or optical system that may be controlled by the optical image stabilizer (e.g., image stabilizer (240) of FIG. 2 or optical image stabilizer (723) of FIG. 7). In addition, when the first OIS position is symmetrical with the second OIS position, data at the second OIS position may be generated from data at the first OIS position in a symmetrical relationship with the first OIS position. Or, vice versa. For example, referring to FIG. 12, a calibration value of a first light-receiving element (e.g., first light-receiving element (631) of FIG. 6 or light-receiving element (LT) of FIG. 12) may be symmetrical with a calibration value of a second light-receiving element (e.g., first light-receiving element (632) of FIG. 6 or light-receiving element (RT) of FIG. 12) with respect to a longitudinal axis passing through the center point of an OIS movement area. The calibration value of the first light-receiving element (e.g., first light-receiving element (631) of FIG. 6 or light-receiving element (LT) of FIG. 12) may also be symmetrical with a calibration value of a third light-receiving element (e.g., light-receiving element (RB) of FIG. 12) with respect to the center point of the OIS movement area. The calibration value of the first light-receiving element (e.g., first light-receiving element (631) of FIG. 6 or light-receiving element (LT) of FIG. 12) may be symmetrical with a calibration value of a fourth light-receiving element (e.g., fourth light-receiving element (634) of FIG. 6 or light-receiving element (LB) of FIG. 12) with respect to a transverse axis passing through the center point of the OIS movement area. Accordingly, a second gain calibration value (1211-2) of the first light-receiving element (e.g., first light-receiving element (631) of FIG. 6 or light-receiving element (LT) of FIG. 12) may have a symmetrical relationship with a twelfth gain calibration value (1214-3) of the fourth light-receiving element (e.g., fourth light-receiving element (634) of FIG. 6 or light-receiving element (RB) of FIG. 12) for which the optical image stabilizer moves symmetrically with respect to the center point of the OIS movement area. The twelfth gain calibration value (1214-3) may be acquired by performing a rotation conversion for the second gain calibration value (1211-2). By utilizing this characteristic, a calibration value at each OIS position symmetrical with respect to the longitudinal axis, the transverse axis, and the center point may be predicted through only the calibration value at the first OIS position.

For example, the second OIS position may also include a position where a focal length of the camera is different from that of the first OIS position.

The second image data may be an image obtained by photographing a surface light source having a constant gain over the entire area, based on the second OIS position.

The first image data and the second image data may not be images captured by a sensor to be actually calibrated, but may be arbitrary image data modified by extracting common portions from other sensors. The image capturing process described in the embodiment may be partially or entirely omitted.

According to an embodiment, operations 1010 and 1020 may be performed in a state where other settings (e.g., exposure value and white balance parameter) of the camera (e.g., camera module (180) of FIGS. 1 and 2) are maintained. Operations 1010 and 1020 may be also performed respectively for different positions of the auto focus (AF) adjuster. For example, at least one of operations 1010 and 1020 may be performed while the position of the auto focus adjuster is changed two or more times.

According to an embodiment, in operation 1030, a gain calibration value for each OIS position may be acquired based on at least the first image data and the second image data. The gain calibration value for each OIS position may be acquired without capturing all frames for all OIS positions at which the optical image stabilizer (e.g., image stabilizer (240) of FIG. 2 or optical image stabilizer (723) of FIG. 7) may be controlled. The shading effect appearing at each OIS position may have symmetry with respect to light-receiving elements arranged at positions corresponding to a micro lens. For example, the shading effect appearing at each OIS position may have symmetry with respect to a center point of an area in which the optical image stabilizer may move or a vicinity of the center point. In an embodiment, by utilizing the symmetry, the electronic device (e.g., electronic device (101) of FIG. 1 or electronic device (101) of FIG. 7) may acquire gain calibration values for all OIS positions from image frames captured based on some OIS positions.

According to an embodiment, in operation 1040, the electronic device (e.g., electronic device (101) of FIG. 1 or electronic device (101) of FIG. 7) may store the gain calibration value for each OIS position in a memory (e.g., memory (130) of FIG. 1 or memory (713) of FIG. 7). For example, the electronic device (e.g., electronic device (101) of FIG. 1 or electronic device (101) of FIG. 7) may store a look-up table that associates and stores the gain calibration value for each OIS position, in the memory (e.g., memory (130) of FIG. 1 or memory (713) of FIG. 7). The electronic device (e.g., electronic device (101) of FIG. 1 or electronic device (101) of FIG. 7) may be configured to determine a gain calibration value corresponding to a corresponding OIS position from the look-up table, based on image stabilizer operation information corresponding to the OIS position.

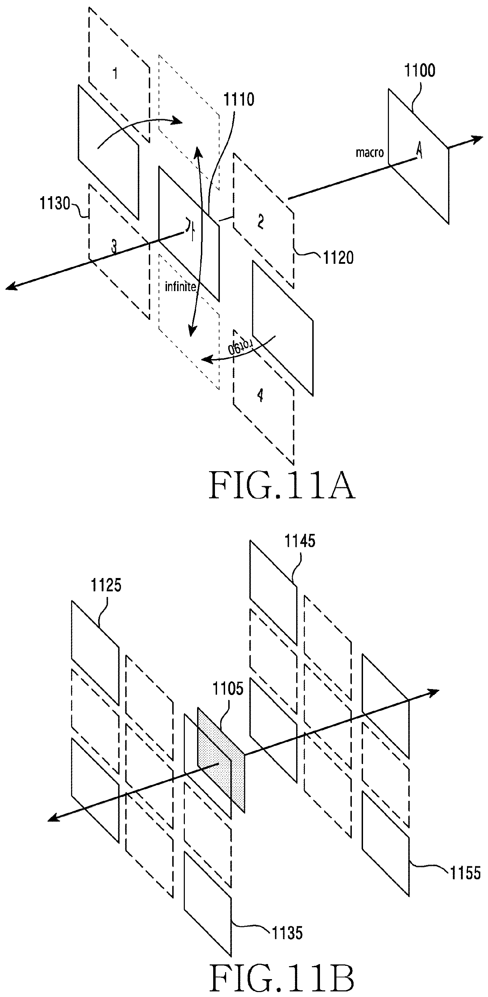

FIG. 11 is a conceptual diagram illustrating the position of a lens or image sensor related to the operation of an optical image stabilizer for acquiring a gain calibration value according to an embodiment.

In an embodiment, in a calibration operation of calibrating a gain value for correcting a shading effect, a camera (e.g., camera module (180) of FIGS. 1 and 2) may photograph a surface light source having a constant gain over the entire area. In the calibration operation, the camera (e.g., camera module (180) of FIGS. 1 and 2) may move a relative position or direction between a lens and an image sensor by using the optical image stabilizer (e.g., image stabilizer (240) of FIG. 2 or optical image stabilizer (723) of FIG. 7), and then photograph the surface light source again. To move the relative position or direction between the lens and the image sensor, the camera (e.g., camera module (180) of FIGS. 1 and 2) may move at least one of the lens or the image sensor. In this document, for the convenience of explanation, the operation of moving the relative position or direction between the lens and the image sensor by using the optical image stabilizer (e.g., image stabilizer (240) of FIG. 2 or optical image stabilizer (723) of FIG. 7) may be referred to as 'moving the position of the optical image stabilizer (or OIS position)'. In the calibration process, the camera (e.g., camera module (180) of FIGS. 1 and 2) may perform multiple times of a process of moving the position of the optical image stabilizer (e.g., image stabilizer (240) of FIG. 2 or optical image stabilizer (723) of FIG. 7) and then photographing the surface light source again. In the calibration process, after changing a focus position, the camera (e.g., camera module (180) of FIGS. 1 and 2) may photograph the surface light source again. The camera (e.g., camera module (180) of FIGS. 1 and 2) may move the position of the focus lens or image sensor such that the length of an optical path from the focus lens to the image sensor is changed to adjust the focus position. In the calibration process, the camera (e.g., camera module (180) of FIGS. 1 and 2) may perform multiple times of a process of changing the focus position and then photographing the surface light source again.

In an embodiment, referring to FIG. 11 (a), the camera (e.g., camera module (180) of FIGS. 1 and 2) may obtain an image of a surface light source, based on a first position (1110). The camera (e.g., camera module (180) of FIGS. 1 and 2) may obtain an image of the surface light source, based on a second position (1120) that is an OIS position moved from the first position (1110). The camera (e.g., camera module (180) of FIGS. 1 and 2) may obtain an image of the surface light source, based on a third position (1130). The camera (e.g., camera module (180) of FIGS. 1 and 2) may obtain an image of the surface light source, based on a fourth position (1100) obtained by moving the focus position from the first position (1110). In an embodiment, the electronic device (e.g., electronic device (101) of FIG. 1 or electronic device (101) of FIG. 7) may acquire a look-up table including a gain calibration value from the images of the surface light source.

In an embodiment, referring to FIG. 11 (b), the camera (e.g., camera module (180) of FIGS. 1 and 2) may obtain an image of a surface light source, based on a fifth position (1105). The fifth position (1105) may be a center point of an operation range of the optical image stabilizer. The fifth position (1105) may be specified regardless of the focal length of the camera (e.g., camera module (180) of FIGS. 1 and 2). The camera (e.g., camera module (180) of FIGS. 1 and 2) may obtain an image of the surface light source, based on a sixth position (1125) obtained by moving an OIS position and a focus position from the fifth position (1105). The camera (e.g., camera module (180) of FIGS. 1 and 2) may obtain an image of the surface light source, based on a seventh position (1135) having the same focus position as and a different OIS position from the sixth position (1125). The camera (e.g., camera module (180) of FIGS. 1 and 2) may obtain images of the surface light source, based on an eighth position (1145) and a ninth position (1155) having different focus positions from those of the sixth position (1125) and the seventh position (1135). The OIS position of the eighth position (1145) may be also different from that of the sixth position (1125). The OIS position of the ninth position (1155) may be also different from that of the seventh position (1135). The electronic device (e.g., electronic device (101) of FIG. 1 or electronic device (101) of FIG. 7) may acquire a look-up table including a gain calibration value from images of a surface light source photographed respectively at a plurality of positions.

However, the positions for capturing the images illustrated in FIG. 11 (a) or (b) are provided as examples, and the electronic device (e.g., electronic device (101) of FIG. 1 or electronic device (101) of FIG. 7) may also acquire a look-up table from images of a surface light source photographed at different positions in order to measure the shading effect according to the operation state of the optical image stabilizer during photographing. When the electronic device (e.g., electronic device (101) of FIG. 1 or electronic device (101) of FIG. 7) uses a look-up table common for a plurality of sensors, a process of capturing images to obtain data for calibrating the sensors may be partially or entirely also omitted. That is, the operation of capturing the images and obtaining the data may be partially or entirely omitted, and a gain of the sensor may be calibrated using data applied to other sensors. The electronic device (e.g., electronic device (101) of FIG. 1 or electronic device (101) of FIG. 7) may obtain two pieces of image data captured based on different auto-focus (AF) positions at a center point of an area where the optical image stabilizer may move, in order to obtain data for calibration for an auto-focus adjustment operation.

FIG. 12 is a diagram conceptually illustrating a gain calibration value acquired according to an embodiment. FIG. 12 conceptually illustrates a look-up table including a gain calibration value for each light-receiving element or a gain calibration value for each OIS position according to an embodiment.

Referring to FIG. 12, a look-up table may include frames captured for a plurality of OIS positions for light-receiving elements (e.g., light-receiving elements (631, 632, 633, 634, 641, 642, 643, 644, 651, 652, 653, 654, 661, 662, 663, and 664 of FIG. 6) according to a pattern constituting an image sensor (e.g., image sensor (230) of FIG. 2 or image sensor (703) of FIG. 7). For example, the look-up table may include frames captured for a 5 x 5 number of OIS positions for four light-receiving elements (e.g., first light-receiving element (631) arranged at first position in FIG. 6, second light-receiving element (632) arranged at second position adjacent in first direction from first light-receiving element (631), third light-receiving element (633) arranged at third position adjacent in second direction from first light-receiving element (631), and fourth light-receiving element (634) arranged at fourth position adjacent to second light-receiving element (632) and third light-receiving element (633)). When all of 25 OIS positions are captured in the calibration process, the number of procedures to be performed for calibration may increase. Therefore, a gain calibration value for a corresponding position may be acquired by capturing images based on some positions among the 5 x 5 number of OIS positions. Gain calibration values for the remaining OIS positions may be acquired using the symmetry, based on the acquired gain calibration value.

In an embodiment, the look-up table may include a first gain calibration value (1211-1) that is based on an image captured through a first light-receiving element (LT) (e.g., first light-receiving element (631) of FIG. 6) at a first position (e.g., first position (1110) of FIG. 11). A second gain calibration value (1211-2) may be based on an image captured through the first light-receiving element (LT) (e.g., first light-receiving element (631) of FIG. 6) at a second position (e.g., second position (1120) of FIG. 11). A third gain calibration value (1211-3) may be based on an image captured through the first light-receiving element (LT) (e.g., first light-receiving element (631) of FIG. 6) at a third position (e.g., third position (1130) of FIG. 11). A gain calibration value for a position between two positions may be estimated from gain calibration values of the two positions. For example, a gain calibration value for a position between the first position (1110) and the second position (1120) may be acquired by interpolating a gain calibration value of the first position and a gain calibration value of the second position.

In an embodiment, data (1211-4) for an OIS position of (-3 deg, -3 deg) related to the first light-receiving element (LT) (e.g., first light-receiving element (631) of FIG. 6) is not included in an image captured through the first light-receiving element (LT) (e.g., first light-receiving element (631) of FIG. 6). However, the data for the OIS position of (-3 deg, -3 deg) related to the first light-receiving element (LT) (e.g., first light-receiving element (631) of FIG. 6) may be estimated by flipping data (fifth gain calibration value (1212-2)) for an OIS position of (+3 deg, -3 deg) through a second light-receiving element (RT) (e.g., second light-receiving element (632) of FIG. 6). Similarly, a first gain calibration value table (1210) for all OIS positions related to light-receiving elements (LT, RT, LB, and RB) (e.g., first light-receiving element (631), second light-receiving element (632), third light-receiving element (633), and fourth light-receiving element (634)) arranged at positions corresponding to a first micro lens (e.g., first micro lens (611) of FIG. 6) may be acquired based on a fourth gain calibration value (1212-1), a fifth gain calibration value (1212-2), a sixth gain calibration value (1212-3), a seventh gain calibration value (1213-1), an eighth gain calibration value (1213-2), a ninth gain calibration value (1213-3), a tenth gain calibration value (1214-1), an eleventh gain calibration value (1214-2), and a twelfth gain calibration value (1214-3).

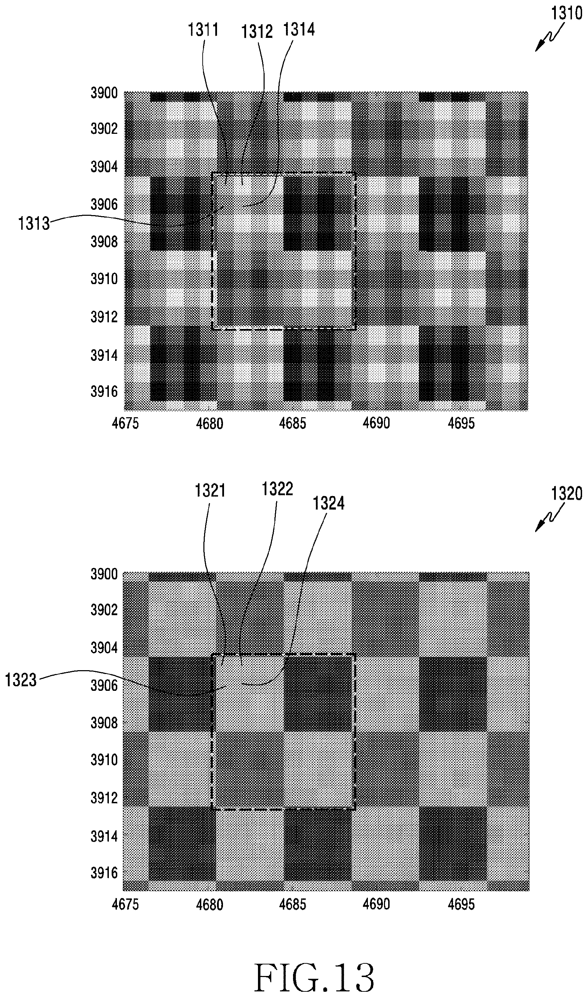

FIG. 13 is a diagram schematically illustrating output values of pixels output from an image sensor (e.g., image sensor (230) of FIG. 2 or image sensor (703) of FIG. 7) according to an embodiment. FIG. 13 is an exemplary diagram schematically illustrating output values of pixels output from an image sensor (e.g., image sensor (230) of FIG. 2 or image sensor (703) of FIG. 7), in which the pattern illustrated in FIG. 6 (a) is repeated. The output values illustrated in FIG. 13 illustrate pixel values prior to demosaic processing. The demosaic processing may refer to an operation performed to obtain a color image from an image (e.g., image consisting of Bayer pattern) that is not a color image (e.g., RGB image).

A first image (1310) illustrated in FIG. 13 may include data that is output in a state where a gain value is not calibrated. A difference may be large between a first output value (1311) of a first light-receiving element (e.g., first light-receiving element (631) of FIG. 6), a second output value (1312) of a second light-receiving element (e.g., second light-receiving element (632) of FIG. 6), a third output value (1313) of a third light-receiving element (e.g., third light-receiving element (633) of FIG. 6), and a fourth output value (1314) of a fourth light-receiving element (e.g., fourth light-receiving element (634) of FIG. 6), which are included in the first image (1310).

A second image (1320) illustrated in FIG. 13 may include data that is output in a state where a gain value is calibrated. In an embodiment, a difference may be relatively reduced between a first output value (1321) of the first light-receiving element (e.g., first light-receiving element (631) of FIG. 6), a second output value (1322) of the second light-receiving element (e.g., second light-receiving element (632) of FIG. 6), a third output value (1323) of the third light-receiving element (e.g., third light-receiving element (633) of FIG. 6), and a fourth output value (1324) of the fourth light-receiving element (e.g., fourth light-receiving element (634) of FIG. 6), which are included in the second image (1320).

In an embodiment, similarly to the first gain calibration value table (1210), a second gain calibration value table (1220) related to light-receiving elements (e.g., fifth light-receiving element (641), sixth light-receiving element (642), seventh light-receiving element (643), and eighth light-receiving element (644)) arranged at positions corresponding to a second micro lens (e.g., second micro lens (612) of FIG. 6) may be acquired. The second gain calibration value table (1220) may include information for acquiring gain calibration values for color channels different from those of the first gain calibration value table (1210). Similarly to the first gain calibration value table (1210), a third gain calibration value table (1230) related to light-receiving elements (e.g., ninth light-receiving element (651), tenth light-receiving element (652), eleventh light-receiving element (653), and twelfth light-receiving element (654)) arranged at positions corresponding to a third micro lens (e.g., third micro lens (613) of FIG. 6) may be acquired. Similarly to the first gain calibration value table (1210), a fourth gain calibration value table (1240) related to light-receiving elements (e.g., thirteenth light-receiving element (661), fourteenth light-receiving element (662), fifteenth light-receiving element (663), and sixteenth light-receiving element (664)) arranged at positions corresponding to a fourth micro lens (e.g., fourth micro lens (614) of FIG. 6) may be acquired.

In an embodiment, the electronic device (e.g., electronic device (101) of FIG. 1 or electronic device (101) of FIG. 7) may store only data (e.g., 1212-1, 1211-2, 1211-3, 1212-1, 1212-2, 1212-3, 1213-1, 1213-2, 1213-3, 1214-1, 1214-2, and 1214-3) that are based on captured images, in the memory (e.g., memory (713) of FIG. 7). The format of the data stored in the memory (e.g., memory (713) of FIG. 7) may be implemented in various ways. For example, the result of performing a binning calculation for a captured image may be stored in the memory (e.g., memory (713) of FIG. 7). For example, a representative value similar to an actual capture value may be also stored in the memory (e.g., memory (713) of FIG. 7). For example, a compressed value obtained by processing data included in the captured image may be also stored in the memory (713). However, the disclosure is not limited thereto. When the electronic device (e.g., electronic device (101) of FIG. 1 or electronic device (101) of FIG. 7) captures an image through a camera (e.g., camera module (180) of FIGS. 1 and 2), the electronic device may obtain image stabilizer operation information related to an OIS position of an optical image stabilizer (e.g., image stabilizer (240) of FIG. 2 or optical image stabilizer (723) of FIG. 7). The electronic device (e.g., electronic device (101) of FIG. 1 or electronic device (101) of FIG. 7) may also acquire a gain calibration value for an OIS position related to an acquired control value by interpolating at least some of the stored data. In an embodiment, the electronic device (e.g., electronic device (101) of FIG. 1 or electronic device (101) of FIG. 7) may also determine a gain calibration value for each light-receiving element from the stored data, based on an AF position related to a focus adjustment operation.

The electronic device (e.g., electronic device (101) of FIG. 1 or electronic device (101) of FIG. 7) of an embodiment may calibrate pixel values output from respective light-receiving elements, based on the determined gain calibration value.

An electronic device (e.g., electronic device 101 of FIG. 1 or electronic device 101 of FIG. 7) of an embodiment may include a camera module (e.g., camera module of FIGS. 1 and 2) including a camera, a memory for storing instructions, and at least one processor (e.g., processor 120 of FIG. 1) operatively connected to the camera module (e.g., camera module 180 of FIGS. 1 and 2) and the memory (e.g., memory 130 of FIG. 1 or memory 713 of FIG. 7). The camera module (e.g., camera module 180 of FIGS. 1 and 2) may include a lens unit (e.g., lens assembly of FIG. 2) including at least one lens, an image sensor (e.g., image sensor 230 of FIG. 2 or image sensor 703 of FIG. 7) for converting received light into an electrical signal, and an optical image stabilizer (e.g., image stabilizer 240 of FIG. 2 or optical image stabilizer 723 of FIG. 7) configured to control the position of at least one of the lens unit (e.g., lens assembly of FIG. 2) or the image sensor (e.g., image sensor 230 of FIG. 2 or image sensor 703 of FIG. 7), based on the movement of the electronic device (e.g., electronic device 101 of FIG. 1 or electronic device 101 of FIG. 7). The image senor (e.g., image sensor 230 of FIG. 2 or image sensor 703 of FIG. 7) may include a micro lens (e.g., micro lenses 611, 612, 613 and 614 of FIG. 6), and a plurality of light-receiving elements (e.g., light-receiving elements 631, 632, 633 and 634 of FIG. 6) arranged at positions corresponding to the micro lens (e.g., micro lenses 611, 612, 613 and 614 of FIG. 6). The instructions may, being executed by the at least one processor (e.g., processor 120), cause the electronic device (e.g., electronic device 101 of FIG. 1 or electronic device 101 of FIG. 7) to acquire a gain calibration value corresponding to image stabilizer operation information about the position of the optical image stabilizer (e.g., image stabilizer 240 of FIG. 2 or optical image stabilizer 723 of FIG. 7). The instructions may, being executed by the at least one processor (e.g., processor 120), cause the electronic device (e.g., electronic device 101 of FIG. 1 or electronic device 101 of FIG. 7) to, according to the controlling of the operation of the optical image stabilizer (e.g., image stabilizer 240 of FIG. 2 or optical image stabilizer 723 of FIG. 7) based on the image stabilizer operation information, obtain image data from the plurality of light-receiving elements (e.g., light-receiving elements 631, 632, 633 and 634 of FIG. 6), based on the gain calibration value corresponding to the image stabilizer operation information.

In an embodiment, the plurality of light-receiving elements (e.g., light-receiving elements 631, 632, 633 and 634 of FIG. 6) may include a 2 x 2 array of light-receiving elements (e.g., light-receiving elements 631, 632, 633 and 634 of FIG. 6) arranged at the positions corresponding to the micro lens (e.g., micro lenses 611, 612, 613 and 614 of FIG. 6). The image sensor (e.g., image sensor 230 of FIG. 2 or image sensor 703 of FIG. 7) may include a color filter having a single color channel in an area corresponding to the micro lens (e.g., micro lenses 611, 612, 613 and 614 of FIG. 6).

In an embodiment, the gain calibration value may include a plurality of gain calibration values corresponding respectively to the plurality of light-receiving elements (e.g., light-receiving elements 631, 632, 633 and 634 of FIG. 6). The memory (e.g., memory 130 of FIG. 1 or memory 713 of FIG. 7) may store a look-up table that includes the plurality of gain calibration values stored in association with the image stabilizer operation information, or information for acquiring the plurality of gain calibration values. The instructions may, being executed by the at least one processor (e.g., processor 120), cause the electronic device (e.g., electronic device 101 of FIG. 1 or electronic device 101 of FIG. 7) to acquire the plurality of gain calibration values from the look-up table, based on the image stabilizer operation information.

In an embodiment, the look-up table may include data that is generated for the plurality of light-receiving elements (e.g., light-receiving elements 631, 632, 633 and 634 of FIG. 6), based on data including first data captured in a state where the optical image stabilizer (e.g., image stabilizer 240 of FIG. 2 or optical image stabilizer 723 of FIG. 7) is in a first position, second data captured in a state where the optical image stabilizer is in a second position, and third data captured in a state where the optical image stabilizer is in a third position corresponding to a focus position different from the first position and the second position.

In an embodiment, the optical image stabilizer (e.g., image stabilizer 240 of FIG. 2 or optical image stabilizer 723 of FIG. 7) may include a carrier movable within the camera module (e.g., camera module 180 of FIGS. 1 and 2), and a position sensor for detecting position information associated with the carrier. The instructions may, being executed by the at least one processor (e.g., processor 120), cause the electronic device (e.g., electronic device 101 of FIG. 1 or electronic device 101 of FIG. 7) to obtain, through the position sensor, the image stabilizer operation information associated with a time point when the image data is read out from the image sensor (e.g., image sensor 230 of FIG. 2 or image sensor 703 of FIG. 7). The instructions may, being executed by the at least one processor (e.g., processor 120), cause the electronic device (e.g., electronic device 101 of FIG. 1 or electronic device 101 of FIG. 7) to acquire the gain calibration value stored in the memory (e.g., memory 130 of FIG. 1 or memory 713 of FIG. 7), based on the obtained image stabilizer operation information. The instructions may, being executed by the at least one processor (e.g., processor 120), cause the electronic device (e.g., electronic device 101 of FIG. 1 or electronic device 101 of FIG. 7) to obtain the image data, based on pixel values that are read out from the plurality of light-receiving elements (e.g., light-receiving elements 631, 632, 633 and 634 of FIG. 6), based on the gain calibration value.

In an embodiment, the electronic device (e.g., electronic device 101 of FIG. 1 or electronic device 101 of FIG. 7) may further include a focus adjuster for adjusting the focus of an image formed on the image sensor (e.g., image sensor 230 of FIG. 2 or image sensor 703 of FIG. 7) by moving at least one of the at least one lens. The instructions may, being executed by the at least one processor (e.g., processor 120), cause the electronic device (e.g., electronic device 101 of FIG. 1 or electronic device 101 of FIG. 7) to receive the image stabilizer operation information from the optical image stabilizer (e.g., image stabilizer 240 of FIG. 2 or optical image stabilizer 723 of FIG. 7). The instructions may, being executed by the at least one processor (e.g., processor 120), cause the electronic device (e.g., electronic device 101 of FIG. 1 or electronic device 101 of FIG. 7) to obtain the image data from the image sensor (e.g., image sensor 230 of FIG. 2 or image sensor 703 of FIG. 7), based on the gain calibration value determined based on the image stabilizer operation information. The instructions may, being executed by the at least one processor (e.g., processor 120), cause the electronic device (e.g., electronic device 101 of FIG. 1 or electronic device 101 of FIG. 7) to control the focus adjuster, based on an image signal included in the image data.

In an embodiment, the plurality of light-receiving elements (e.g., light-receiving elements 631, 632, 633 and 634 of FIG. 6) may include a first light-receiving element (e.g., light-receiving element 631 of FIG. 6) and a second light-receiving element (e.g., light-receiving element 632 of FIG. 6). The camera module (e.g., camera module 180 of FIGS. 1 and 2) may be configured to, when the image sensor (e.g., image sensor 230 of FIG. 2 or image sensor 703 of FIG. 7) operates based on a first operation mode, output a first pixel value based on a first gain calibration value for the first light-receiving element (e.g., light-receiving element 631 of FIG. 6), and output a second pixel value based on a second gain calibration value for the second light-receiving element (e.g., light-receiving element 632 of FIG. 6). The camera module (e.g., camera module 180 of FIGS. 1 and 2) may be configured to, when the image sensor (e.g., image sensor 230 of FIG. 2 or image sensor 703 of FIG. 7) operates based on a second operation mode, output a third pixel value obtained by binning the outputs of the first light-receiving element (e.g., light-receiving element 631 of FIG. 6) and the second light-receiving element (e.g., light-receiving element 632 of FIG. 6), based on a third gain calibration value for the first light-receiving element (e.g., light-receiving element 631 of FIG. 6) and the second light-receiving element (e.g., light-receiving element 632 of FIG. 6).

**In** an embodiment, the memory (e.g., memory 130 of FIG. 1 or memory 713 of FIG. 7) may store the first gain calibration value, the second gain calibration value, and the third gain calibration value.

In an embodiment, the memory (e.g., memory 130 of FIG. 1 or memory 713 of FIG. 7) may be configured to store the first gain calibration value and the second gain calibration value. The camera module (e.g., camera module 180 of FIGS. 1 and 2) may be configured to acquire the third gain calibration value by performing a calculation from the first gain calibration value and the second gain calibration value at the time of operating based on the second operation mode.

In an embodiment, the image sensor (e.g., image sensor 230 of FIG. 2 or image sensor 703 of FIG. 7) may include a plurality of sensing lines. Each of the plurality of sensing lines may include at least two or more of the plurality of light-receiving elements (e.g., light-receiving elements 631, 632, 633 and 634 of FIG. 6). The image sensor (e.g., image sensor 230 of FIG. 2 or image sensor 703 of FIG. 7) may be configured to read out the pixel values, based on gain calibration values for at least two or more light-receiving elements included in a sensing line that reads out the pixel values among the plurality of sensing lines.

In an embodiment, the memory (e.g., memory 130 of FIG. 1 or memory 713 of FIG. 7) may store a look-up table generated based on the symmetry of the gain calibration value dependent on the position of the optical image stabilizer (e.g., image stabilizer 240 of FIG. 2 or optical image stabilizer 723 of FIG. 7).

A method for acquiring a gain calibration value for calibrating a gain value used to read out a pixel value from an image sensor (e.g., image sensor 230 of FIG. 2 or image sensor 703 of FIG. 7) included in a camera module (e.g., camera module 180 of FIGS. 1 and 2) according to an embodiment may include capturing a first image in a state where an optical image stabilizer (e.g., image stabilizer 240 of FIG. 2 or optical image stabilizer 723 of FIG. 7) included in the camera module (e.g., camera module 180 of FIGS. 1 and 2) is moved to a first position. The method may further include capturing a second image in a state where the optical image stabilizer (e.g., image stabilizer 240 of FIG. 2 or optical image stabilizer 723 of FIG. 7) is moved to a second position different from the first position. The method may further include acquiring gain calibration values for a respective plurality of positions of the optical image stabilizer (e.g., image stabilizer 240 of FIG. 2 or optical image stabilizer 723 of FIG. 7) from at least the first image and the second image. The method may include storing a look-up table including the gain calibration values in the memory (e.g., memory 130 of FIG. 1 or memory 713 of FIG. 7).

In an embodiment, the capturing of the first image and the capturing of the second image may be performed in a state where a focus adjuster included in the camera module (e.g., camera module 180 of FIGS. 1 and 2) is in a third position. The method may further include capturing a third image in a state where the focus adjuster is in a fourth position different from the third position. The acquiring of the gain calibration value may include acquiring gain calibration values for the respective plurality of positions of the optical image stabilizer (e.g., image stabilizer 240 of FIG. 2 or optical image stabilizer 723 of FIG. 7) from at least the first image, the second image, and the third image.

In an embodiment, the image sensor (e.g., image sensor 230 of FIG. 2 or image sensor 703 of FIG. 7) may include a micro lens (e.g., micro lenses 611, 612, 613 and 614 of FIG. 6) and a plurality of light-receiving elements (e.g., light-receiving elements 631, 632, 633 and 634 of FIG. 6) arranged at positions corresponding to the micro lens (e.g., micro lenses 611, 612, 613 and 614 of FIG. 6).

In an embodiment, the plurality of light-receiving elements (e.g., light-receiving elements 631, 632, 633 and 634 of FIG. 6) may include light-receiving elements (e.g., light-receiving elements 631, 632, 633 and 634 of FIG. 6) arranged in a 2 x 2 array at the positions corresponding to the micro lens (e.g., micro lenses 611, 612, 613 and 614 of FIG. 6).

In an embodiment, the acquiring of the gain calibration values may include acquiring the gain calibration values from the first image and the second image in consideration of a symmetry relationship of the light-receiving elements (e.g., light-receiving elements 631, 632, 633 and 634 of FIG. 6).

A computer-readable non-transitory recording medium may store a look-up table including gain calibration values including a first gain calibration value corresponding to a first image captured by an image sensor (e.g., image sensor 230 of FIG. 2 or image sensor 703 of FIG. 7) of a camera module (e.g., camera module 180 of FIGS. 1 and 2) in a state where an optical image stabilizer (e.g., image stabilizer 240 of FIG. 2 or optical image stabilizer 723 of FIG. 7) included in the camera module (e.g., camera module 180 of FIGS. 1 and 2) is moved to a first position, and a second gain calibration value corresponding to a second image captured by the image sensor (e.g., image sensor 230 of FIG. 2 or image sensor 703 of FIG. 7) of the camera module (e.g., camera module 180 of FIGS. 1 and 2) in a state where the optical image stabilizer (e.g., image stabilizer 240 of FIG. 2 or optical image stabilizer 723 of FIG. 7) is moved to a second position different from the first position.

In an embodiment, the first image and the second image may be captured in a state where a focus adjuster included in the camera module (e.g., camera module 180 of FIGS. 1 and 2) is in a third position. The look-up table may include gain calibration values acquired by further considering a third image captured in a state where the focus adjuster is in a fourth position different from the third position.

In an embodiment, the image sensor (e.g., image sensor 230 of FIG. 2 or image sensor 703 of FIG. 7) may include a micro lens (e.g., micro lenses 611, 612, 613 and 614 of FIG. 6) and a plurality of light-receiving elements (e.g., light-receiving elements 631, 632, 633 and 634 of FIG. 6) arranged at positions corresponding to the micro lens (e.g., micro lenses 611, 612, 613 and 614 of FIG. 6).

In an embodiment, the plurality of light-receiving elements (e.g., light-receiving elements 631, 632, 633 and 634 of FIG. 6) may include light-receiving elements (e.g., light-receiving elements 631, 632, 633 and 634 of FIG. 6) arranged in a 2 x 2 array at positions corresponding to the micro lens (e.g., micro lenses 611, 612, 613 and 614 of FIG. 6).

In an embodiment, it may be characterized that the gain value is acquired in consideration of a symmetrical relationship between the light-receiving elements (e.g., light-receiving elements 631, 632, 633 and 634 of FIG. 6).

According to various embodiments, the electronic device and the image processing method capable of improving an image quality by reducing image quality degradation caused by the operation of an optical image stabilizer may be provided.

According to various embodiments, the electronic device and the image processing method capable of removing or reducing shading artifacts in an image obtained through an image sensor having symmetrical phase detection pixels may be provided.

According to various embodiments, the electronic device and the image processing method capable of improving an image resolution by correcting the shading artifacts that may appear in the image may be provided.

According to various embodiments, the performance of an auto-focus function may be improved by correcting the shading artifacts that may appear in the image.

Effects obtainable from the disclosure are not limited to the effects mentioned above, and other effects not mentioned may be clearly understood by those skilled in the art to which the disclosure pertains from the description below.

The methods of the embodiments described in the claims or specification of the disclosure may be implemented in the form of hardware, software, or a combination of hardware and software.

In the case of software implementation, a computer-readable storage medium that stores one or more programs (software modules) may be provided. The one or more programs stored in the computer-readable storage medium are configured for execution by one or more processors within an electronic device. The one or more programs include instructions of allowing the electronic device to execute the methods of the embodiments described in the claims or specification of the disclosure.

These programs (software modules and software) may be stored in random access memory, non-volatile memory including flash memory, read only memory (ROM), electrically erasable programmable ROM (EEPROM), magnetic disc storage device, compact disc-ROM (CD-ROM), digital versatile discs (DVDs) or other forms of optical storage devices, magnetic cassette. Alternately, the programs may be stored in memories composed of a combination of some or all of them. In addition, each composed memory may be included in multiple as well.

In the disclosure, functions or operations performed by an electronic device may be performed by one or more processors executing one or more instructions included in a program stored in a memory. The functions or operations of the electronic device mentioned in the disclosure may be performed by one processor executing the one or more instructions, or by a combination of a plurality of processors executing the one or more instructions. The processor mentioned in the disclosure may be understood to include circuitry for performing calculations or controlling other components of the electronic device. For example, the one or more processors may include a central processing unit (CPU), a microprocessor unit (MPU), an application processor (AP), a communication processor (CP), a neural processing unit (NPU), a system on chip (SoC), or an integrated circuit (IC), which is configured to execute the one or more instructions. The one or more processors may be configured to perform the operations of the electronic device described above.

In the disclosure, these programs (software modules and software) may be stored in random access memory, non-volatile memory including flash memory, read only memory (ROM), electrically erasable programmable ROM (EEPROM), magnetic disc storage device, compact disc-ROM (CD-ROM), digital versatile discs (DVDs) or other forms of optical storage devices, magnetic cassette. Alternately, the programs may be stored in memories composed of a combination of some or all of them. The memory may be configured as a single storage medium or may be configured as a combination of a plurality of storage media. The one or more instructions may be stored in the single storage medium, or may be distributed and stored in the plurality of storage media.

In addition, the program may be stored in an attachable storage device that may be accessed through a communication network such as Internet, intranet, local area network (LAN), wide LAN (WLAN), or storage area network (SAN) or a communication network composed of a combination thereof. This storage device may be connected to a device performing an embodiment of the disclosure through an external port. In addition, a separate storage device on the communication network may be connected to a device performing an embodiment of the disclosure as well.

In the specific embodiments of the disclosure described above, components included in the disclosure are expressed in the singular or plural form according to the specific embodiments presented. However, the expression of the singular or plural form is selected appropriately for the presented situation for the convenience of explanation, and the disclosure is not limited to singular or plural components, and even components expressed in the plural form may be constructed in the singular form, or even components expressed in the singular form may be constructed in the plural form.

In addition, in the disclosure, the terms "unit", "module", etc. may be hardware components such as processors or circuits, and/or software components executed by the hardware components such as processors.

"Unit" and "module" may be also implemented by a program that may be stored in an addressable storage medium and executed by the processor. For example, "unit" and "module" may be implemented by components such as software components, object-oriented software components, class components, and task components, processes, functions, properties, procedures, subroutines, segments of a program code, drivers, firmware, microcode, circuits, data, databases, data structures, tables, arrays, and variables.

The specific executions described in the disclosure are only an embodiment, and do not limit the scope of the disclosure in any way. For the sake of brevity, descriptions of conventional electronic components, control systems, software, and other functional aspects of the systems may be omitted.

In addition, in the disclosure, "including at least one of a, b, or c" may mean "including only a", "including only b", "including only c", "including a and b", "including b and c", "including a and c", or "including all of a, b, and c".

Meanwhile, although the detailed description of the disclosure has described specific embodiments, it is undoubted that various modifications are possible without departing from the scope of the disclosure. Therefore, the scope of the disclosure should not be limited to the described embodiments, and should be defined not only by the scope of the claims described below but also by equivalents to the scope of the claims.

## Claims

1. An electronic device comprising:
a camera module comprising a camera;
a memory for storing instructions; and
at least one processor operatively connected to the camera module and the memory,
wherein the camera module comprises:
a lens unit comprising at least one lens;
an image sensor for converting received light into an electrical signal; and
an optical image stabilizer configured to control the position of at least one of the lens unit or the image sensor, based on the movement of the electronic device,
the image senor comprises:
a micro lens; and
a plurality of light-receiving elements arranged at positions corresponding to the micro lens, and
the instructions, being executed by the at least one processor, cause the electronic device to:
acquire a gain calibration value corresponding to image stabilizer operation information about the position of the optical image stabilizer; and
according to the controlling of the operation of the optical image stabilizer based on the image stabilizer operation information, obtain image data from the plurality of light-receiving elements, based on the gain calibration value corresponding to the image stabilizer operation information.

2. The electronic device of claim 1, wherein the plurality of light-receiving elements comprise a 2 x 2 array of light-receiving elements arranged at the positions corresponding to the micro lens, and
the image sensor comprises a color filter having a single color channel in an area corresponding to the micro lens.

3. The electronic device of claim 1, wherein the gain calibration value comprises a plurality of gain calibration values corresponding respectively to the plurality of light-receiving elements,
the memory stores a look-up table that comprises the plurality of gain calibration values stored in association with the image stabilizer operation information, or information for acquiring the plurality of gain calibration values, and
the instructions, being executed by the at least one processor, cause the electronic device to acquire the plurality of gain calibration values from the look-up table, based on the image stabilizer operation information.

4. The electronic device of claim 3, wherein the look-up table comprises data that is generated for the plurality of light-receiving elements, based on data comprising first data captured in a state where the optical image stabilizer is in a first position, second data captured in a state where the optical image stabilizer is in a second position, and third data captured in a state where the optical image stabilizer is in a third position corresponding to a focus position different from the first position and the second position.

5. The electronic device of claim 1, wherein the optical image stabilizer comprises:
a carrier movable within the camera module; and
a position sensor for detecting position information associated with the carrier, and
the instructions, being executed by the at least one processor, cause the electronic device to:
obtain, through the position sensor, the image stabilizer operation information associated with a time point when the image data is read out from the image sensor;
acquire the gain calibration value stored in the memory, based on the obtained image stabilizer operation information; and
obtain the image data, based on pixel values that are read out from the plurality of light-receiving elements, based on the gain calibration value.

6. The electronic device of claim 1, further comprising a focus adjuster for adjusting the focus of an image formed on the image sensor by moving at least one of the at least one lens,
wherein the instructions, being executed by the at least one processor, cause the electronic device to:
receive the image stabilizer operation information from the optical image stabilizer;
obtain the image data from the image sensor, based on the gain calibration value determined based on the image stabilizer operation information; and
control the focus adjuster, based on an image signal comprised in the image data.

7. The electronic device of claim 1, wherein the plurality of light-receiving elements comprise a first light-receiving element and a second light-receiving element, and
the camera module is configured to:
when the image sensor operates based on a first operation mode, output a first pixel value based on a first gain calibration value for the first light-receiving element, and output a second pixel value based on a second gain calibration value for the second light-receiving element; and
when the image sensor operates based on a second operation mode, output a third pixel value obtained by binning the outputs of the first light-receiving element and the second light-receiving element, based on a third gain calibration value for the first light-receiving element and the second light-receiving element.

8. The electronic device of claim 7, wherein the memory stores the first gain calibration value, the second gain calibration value, and the third gain calibration value.

9. The electronic device of claim 7, wherein the memory is configured to store the first gain calibration value and the second gain calibration value, and
the camera module is configured to acquire the third gain calibration value by performing a calculation from the first gain calibration value and the second gain calibration value at the time of operating based on the second operation mode.

10. The electronic device of claim 1, wherein the memory stores a look-up table generated based on the symmetry of the gain calibration value dependent on the position of the optical image stabilizer.

11. A method for acquiring a gain calibration value for calibrating a gain value used to read out a pixel value from an image sensor comprised in a camera module, the method comprising:
capturing a first image in a state where an optical image stabilizer comprised in the camera module is moved to a first position;
capturing a second image in a state where the optical image stabilizer is moved to a second position different from the first position;
acquiring gain calibration values for a respective plurality of positions of the optical image stabilizer from at least the first image and the second image; and
storing a look-up table comprising the gain calibration values in the memory.

12. The method of claim 11, wherein the capturing of the first image and the capturing of the second image are performed in a state where a focus adjuster comprised in the camera module is in a third position,
the method further comprises capturing a third image in a state where the focus adjuster is in a fourth position different from the third position, and
the acquiring of the gain calibration value comprises acquiring gain calibration values for the respective plurality of positions of the optical image stabilizer from at least the first image, the second image, and the third image.

13. The method of claim 11, wherein the image sensor comprises a micro lens and a plurality of light-receiving elements arranged at positions corresponding to the micro lens, and
the plurality of light-receiving elements comprise light-receiving elements arranged in a 2 x 2 array at the positions corresponding to the micro lens.

14. The method of claim 13, wherein the acquiring of the gain calibration values comprises acquiring the gain calibration values from the first image and the second image in consideration of a symmetry relationship of the light-receiving elements.

15. A computer-readable non-transitory recording medium,
the recording medium storing a look-up table comprising gain calibration values comprising:
a first gain calibration value corresponding to a first image captured by an image sensor of a camera module in a state where an optical image stabilizer comprised in the camera module is moved to a first position; and
a second gain calibration value corresponding to a second image captured by the image sensor of the camera module in a state where the optical image stabilizer is moved to a second position different from the first position.
